# EUROPEAN PATENT SPECIFICATION

(11) **EP 2 339 731 B1**
(45) Date of publication and mention of the grant of the patent: **16.09.2015**
(21) Application number: 10194217.5
(22) Date of filing: 08.12.2010
(51) Int. Cl.: H01L 41/04, H02M 3/335

(54) **Pulse signal generating circuitry, high-voltage power supplying apparatus and image forming apparatus having the same**
Impulssignalerzeugungsschaltkreis, Hochspannungsversorgungsvorrichtung und Bilderzeugungsgerät damit
Circuit de génération de signal d'impulsion, appareil d'alimentation de courant haute tension et appareil de formation d'images l'utilisant

(30) Priority: 10.12.2009 JP 2009280951; 24.11.2010 JP 2010261727
(43) Date of publication of application: 29.06.2011
(73) Proprietor: Canon Kabushiki Kaisha, Tokyo 146-8501 (JP)
(72) Inventor: Takayama, Yuuji, Ohta-ku Tokyo (JP); Yamaguchi, Atsuhiko, Ohta-ku Tokyo (JP)
(74) Representative: Hitching, Peter Matthew

(56) References cited:
- JP-A- 2009 128 416
- US-A- 5 886 477
- US-A1- 2002 024 269

## Description

### BACKGROUND OF THE INVENTION

### Field of the Invention

The present invention generally relates to a high-voltage power supplying apparatus using a piezoelectric transformer, and particularly relates to pulse signal generating circuitry for use in such apparatus and to an image forming apparatus using the high voltage power supplying apparatus.

### Description of the Related Art

An electrophotographic image forming apparatus needs a high voltage power supplying apparatus to generate a voltage (high voltage) higher than several hundred V. This is because the image forming apparatus applies a DC bias voltage to a transfer member. Although a conventional high voltage power supplying apparatus uses a wire-wound electromagnetic transformer, a recent high voltage power supplying apparatus uses a piezoelectric transformer (piezoelectric ceramic transformer).

Japanese Patent Laid-Open No. 11-206113 discloses a high voltage power supplying apparatus having a voltage-controlled oscillator (VCO) that generates a frequency to be input to a piezoelectric transformer. The piezoelectric transformer has a characteristic that an output voltage is maximum at a resonance frequency. The high voltage power supplying apparatus described in Japanese Patent Laid-Open No. 11-206113 controls the output voltage of the piezoelectric transformer by controlling a frequency output from the VCO.

In general, to increase the output voltage of the piezoelectric transformer, the VCO, for example, changes the frequency of the piezoelectric transformer from a high frequency to a low frequency (or vice versa). The VCO controls the rising time and amount of the output voltage by controlling the change amount of the frequency. Therefore, as a desired voltage becomes higher, the change amount of the frequency becomes larger, thereby prolonging the rising time. In the high voltage power supplying apparatus of an image forming apparatus, for example, as the rising time becomes long, a time taken to start up the apparatus also becomes long. This may prolong a time necessary for preparing for image formation. Reference is likewise made to prior art documents JP-A-2009128416, US-A-5886477 and USA-2002024269.

### SUMMARY OF THE INVENTION

It is desirable to solve at least one of the above and other problems. It is also desirable to improve the rising characteristics of an output voltage in a power supplying apparatus adopting a piezoelectric transformer to shorten a rising time. Other problems will be understood from the entire specification.

A first aspect of the present invention provides pulse signal generating circuitry according to claim 1. Preferred features of the circuitry are set out in claims 2 to 9.

A second aspect of the present invention provides high-voltage power supplying apparatus according to claim 10.

A third aspect of the present invention provides image forming apparatus according to claims 11 and 12.

Further features of the present invention will become apparent from the following description of exemplary embodiments (with reference to the attached drawings).

### BRIEF DESCRIPTION OF THE DRAWINGS

Fig. 1 is a block diagram showing a high voltage power supplying apparatus using a piezoelectric transformer according to an embodiment;
Figs. 2A and 2B are timing charts showing each main signal according to the embodiment;
Fig. 3 is a graph showing the characteristics of an output voltage with respect to the frequency of the piezoelectric transformer;
Fig. 4 is a graph showing a case wherein a target voltage falls within a range in which a spurious frequency is generated, with regard to the characteristics of the output voltage with respect to the frequency of the piezoelectric transformer; and
Fig. 5 is a graph showing the relationship between the output voltage and the frequency of the piezoelectric transformer before and after a load change.

### DESCRIPTION OF THE EMBODIMENTS

The first embodiment of the present invention will be described first.

The present invention switches, step by step, the frequency of a pulse signal to be sent to a piezoelectric transformer, detects a voltage output from the piezoelectric transformer for each frequency, and determines a frequency at which the detected voltage becomes equal to a predetermined target voltage. This operation will be referred to as a sweep operation. Note that the target voltage is set as a voltage needed by a load supplied with a voltage by a high voltage power supplying apparatus. For an image forming apparatus such as a color laser printer, target loads are a charging unit for charging an image carrier, a developing unit for developing a latent image formed on the image carrier, and a transfer unit for transferring a toner image formed on the image carrier onto a printing paper sheet. High voltages to be output to these loads correspond to a charging bias, a developing bias, and a transfer bias.

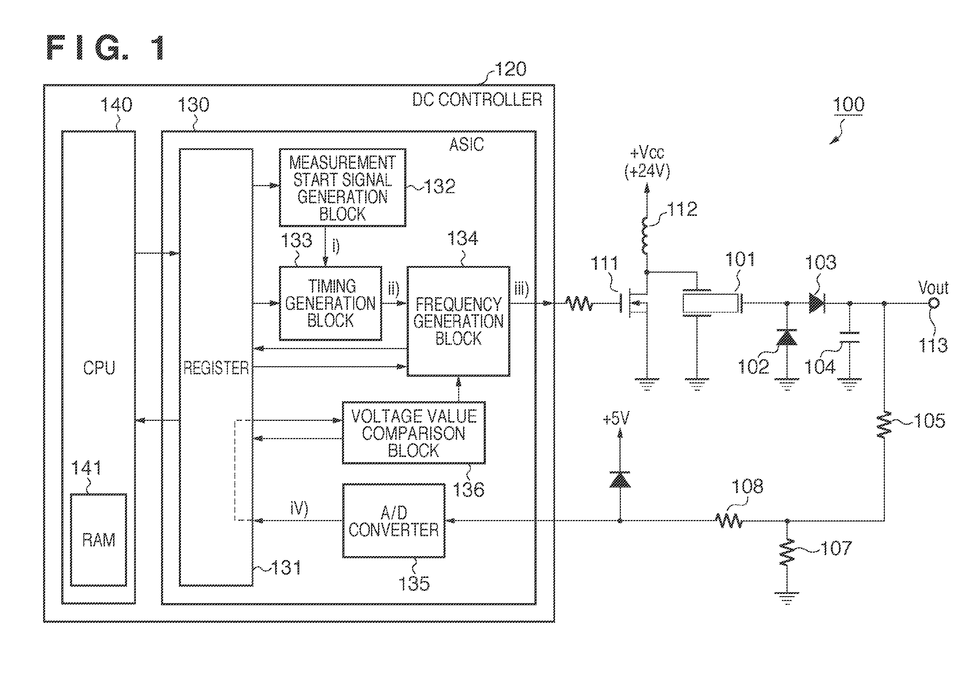

Fig. 1 is a block diagram showing an example of a high voltage power supplying apparatus 100 according to this embodiment. A DC controller 120 serves as a control unit that controls direct current (DC) supply to loads, and is mainly formed by an ASIC 130 and a CPU 140. ASIC is an abbreviation for "Application Specific Integrated Circuit". A piezoelectric transformer 101 outputs a voltage corresponding to the frequency of a pulse signal.

In this embodiment the pulse signal is supplied from the ASIC 130. The ASIC 130 in this embodiment functions as pulse signal generating circuitry. In previously-considered examples of the high voltage power supplying apparatus, the output voltage of the piezoelectric transformer 101 is controlled by the oscillation frequency of a pulse oscillated by an analog circuit including a voltage-controlled oscillator (VCO) connected to the piezoelectric transformer 101. The VCO particularly controls the rising amount and time of the output voltage by controlling the change amount of the frequency. Therefore, as a desired voltage becomes higher, the rising time becomes longer. On the contrary, in the first embodiment, the ASIC 130 generates a pulse signal, and supplies it to the piezoelectric transformer 101. In this way, forming a frequency generation unit and control unit by digital circuits makes it possible to shorten the rising time of the output voltage.

The ASIC 130 forms a feedback control circuit so as to detect a voltage output from the piezoelectric transformer 101. The ASIC 130 acquires a target voltage value output from the CPU 140, and supplies the piezoelectric transformer 101 with a pulse signal with a frequency corresponding to the acquired target voltage value. The pulse signal output from the ASIC 130 is input to a gate terminal of a transistor 111. A drain terminal of the transistor 111 is connected to a positive power supply voltage Vcc via an inductor 112. A source terminal of the transistor 111 is grounded. The drain terminal of the transistor 111 is also connected to the primary side terminal of the piezoelectric transformer 101. Incidentally, although the transistor 111 in the present example is a field-effect transistor (FET) having the above-mentioned gate, drain and source terminals, it will be appreciated that a bipolar transistor could be used instead. In this case, the base, collector and emitter terminals of the bipolar transistor correspond respectively to the gate, drain and source terminals of the FET 111. The primary side terminal of the piezoelectric transformer 101 has a capacitance. The transistor 111 performs a switching operation in accordance with the pulse signal supplied by the ASIC 130. The transistor 111, inductor 112 and the primary side terminal generate a primary-side voltage greater than the pulse-signal voltage by means of an LC resonant circuit formed by the inductance of the inductor 112 and the capacitance of the primary side terminal. Thus, a primary-side voltage of the same frequency as the pulse signal is derived from the pulse signal. The piezoelectric transformer 101 oscillates in response to the voltage supplied to the primary side, and generates, on the secondary side, an alternating-current (AC) voltage, which has been amplified at a step-up ratio corresponding to the size of the piezoelectric transformer 101.

A rectification unit is connected to the secondary side of the piezoelectric transformer 101. That is, the secondary side terminal of the piezoelectric transformer 101 is connected to the cathode terminal of a rectifier diode 102 and the anode terminal of a rectifier diode 103. One terminal of a smoothing capacitor 104 is connected to the cathode terminal of the diode 103. The other terminal of the smoothing capacitor 104 is grounded. The diodes 102 and 103 form a rectifier circuit. The AC voltage output from the secondary side terminal of the piezoelectric transformer 101 is rectified and smoothed by the rectifier circuit and the capacitor 104 to generate a DC output voltage Vout, and this DC output voltage Vout is then supplied to loads through an output terminal 113.

A voltage detection unit is provided to detect the output voltage Vout. The arrangement of the voltage detection unit is as follows. The output terminal 113 is connected to one terminal of a resistor 105. The other terminal of the resistor 105 is connected to one terminal of a resistor 107 and one terminal of a resistor 108. The other terminal of the resistor 108 is connected to a reference voltage source (for example, +5V) for supplying a reference voltage to correctly convert an input voltage. The other terminal of the resistor 107 is grounded. The other terminal of the resistor 108 is also connected to an input terminal of the ASIC 130. Within the ASIC 130 an A/D converter 135 is connected to the input terminal. The resistors 105 and 107 together form a voltage divider that divides the output voltage Vout to generate a reduced voltage suitable for A/D conversion by the A/D converter 135. The reduced voltage is input to the ASIC 130 via the resistor 108. The resistors 105, 107 and 108 together form the voltage detection circuit. This voltage detection circuit is an example of a unit which detects the output voltage Vout of the high voltage power supplying apparatus.

The internal arrangement of the ASIC 130 will be explained next. A register 131 stores data sent from the CPU 140. A measurement start signal generation block 132 generates a start signal (i) for starting the sweep operation based on the data (a value set by the CPU 140) of the register 131. A timing signal generation block 133 starts in response to the start signal (i) sent from the measurement start signal generation block 132, and generates a timing signal (ii) indicating a trigger for switching, step by step, the frequency of the pulse signal to be sent to the piezoelectric transformer 101. A frequency generation block 134 generates the pulse signal (iii). The frequency of the generated pulse signal is switched based on the timing signal sent from the timing signal generation block 133and on a frequency instruction sent from a voltage value comparison block 136. The A/D converter 135 converts an analog signal into a corresponding digital value. The digital value is stored in the register 131. The voltage value comparison block 136 compares the digital value stored in the register 131 with the target voltage value, calculates the difference between the digital value and the target voltage value, and then instructs the frequency generation block 134 about a frequency to be sent to the piezoelectric transformer 101 next. In this embodiment, the voltage value comparison block 136 functions as a control unit which controls the pulse generation unit to increase or decrease the frequency of the pulse signal step by step until the output voltage crosses the target voltage set as the target value of the output voltage. There are two situations in which the output voltage crosses the target voltage. In the first situation, the output voltage is initially below the target voltage and then rises above the target voltage. In the second situation, the output voltage is initially above the target voltage and then falls below the target voltage.

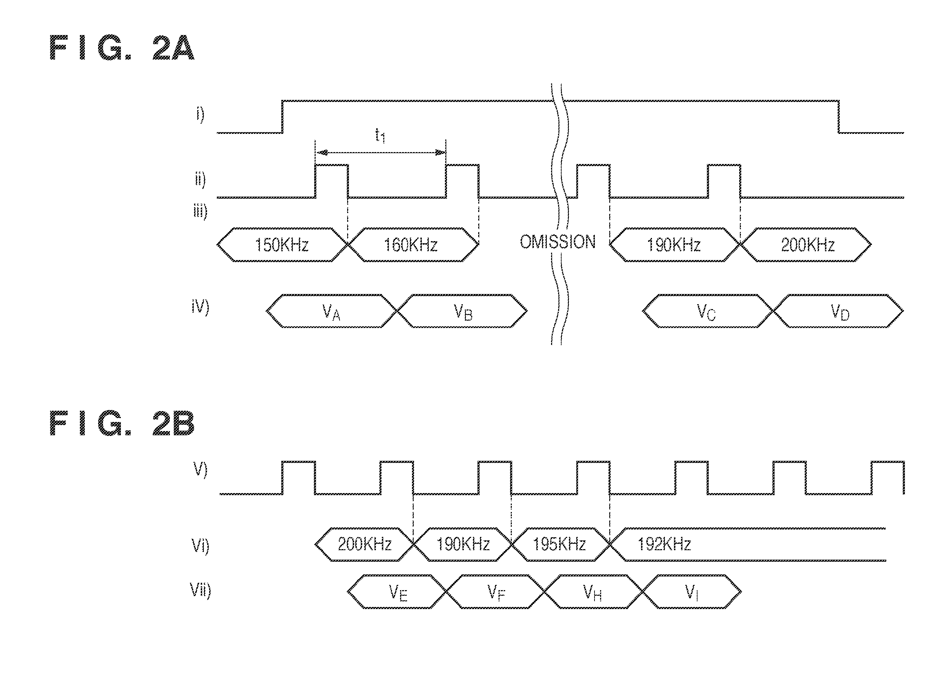

Referring to Fig. 2A, the first line shows the output signal (i) of the measurement start signal generation block 132; the second line shows the output signal (ii) of the timing signal generation block 133; the third line shows the frequency of the pulse signal (iii) output from the frequency generation block 134; and the fourth line shows the digital values VA, VB, VC and VD generated by the A/D converter 135. In this example, assume that VA < VB < VC < VD.

The CPU 140 sets data in the register 131 to cause the ASIC 130 to start measurement. When this data is set in the register 131, the measurement start signal generation block 132 gives the timing signal generation block 133 a measurement start signal (i) shown in Fig. 2A, first line. The timing signal generation block 133 responds to the rise of the measurement signal, and sends, to the frequency generation block 134, a series of timing signals (ii) for switching the frequency of the pulse signal to be sent to the piezoelectric transformer 101. A value, which has been set in the register 131 by the CPU 140, is used as a generation interval t1 at which the timing signal generation block 133 is to generate successive timing signals in the sweep operation. The frequency generation block 134 starts the sweep operation at a first frequency (for example, 150 KHz) as shown in Fig. 2A, third line, prior to the first timing signal (ii) sent from the timing signal generation block 133. After that, the first and each subsequent time the timing signal is generated, the frequency generation block 134 increases the frequency step by step by a predetermined change amount (10 KHz, in this embodiment). In the example shown in Fig. 2A, the block 134 increases the frequency by the predetermined change amount in each step but in other examples the frequency (first frequency) from which the sweep operation starts could be an upper limit frequency and the frequency could be decreased by a predetermined change amount in each step of the sweep operation. The first frequency (150 KHz in this example), used as an initial frequency, is the value which has been stored in the register 131 by the CPU 140. The change amount (10 KHz) is determined by the voltage value comparison block 136 in this embodiment.

After the frequency of the pulse signal (iii) is changed, the secondary side voltage of the piezoelectric transformer 101 and the output voltage Vout also change gradually to a new value. Once the output voltage has settled to this new value the A/D converter 135 converts the output voltage into a corresponding digital value. The digital value indicating the new output voltage is stored in the register 131. To determine whether the output voltage exceeds the target voltage set by the CPU 140, the voltage value comparison block 136 compares the value of the output voltage with that of the target voltage.

Recording a frequency in a RAM 141 when the output voltage exceeds the target voltage will be described next. Once the sweep operation starts, the voltage value comparison block 136 controls the frequency generation block 134 to increase (or decrease) the frequency of the pulse signal (iii) step by step by the predetermined change amount until the output voltage is determined to have exceeded the target voltage. In this example, the output voltage values VA, VB and VC, which correspond to the frequencies 150 KHz, 160 KHz and 190 KHz, are all lower than the target voltage. The output voltage value VD, which corresponds to the frequency 200 KHz, is the first output voltage value to exceed the target voltage. When the output voltage value stored in the register 131 is determined to have exceeded the target voltage value, the voltage value comparison block 136 outputs, to the register 131, a signal for recording, in the register 131, a frequency currently output from the frequency generation block 134. The frequency generation block 134 writes into the register 131 the value of the frequency of the pulse signal currently sent to the piezoelectric transformer 101 into the register 131, based on the frequency recording signal output to the register 131. This frequency is used as an initial frequency in a fine adjustment operation to be carried out after the end of the sweep operation. The CPU 140 also stores, in the RAM 141, the value of the frequency written in the register 131. As described above, in this embodiment, each of the register 131 and the RAM 141 functions as a storage unit which stores data indicating a frequency at which the output voltage exceeds the target voltage.

Although in this embodiment, the RAM 141 stores the value of the frequency at which the output voltage exceeds the target voltage, the value of the frequency may remain stored in the register 131. Once the frequency value has been stored in the RAM 141, the CPU 140 changes the data in the register 131 so that the measurement start signal generation block 132 causes the measurement start signal (i) to fall. This ends the sweep operation. The sweep operation is performed upon power-on or when the CPU 140 determines it necessary. This could include when a change occurs in the load on the high voltage power supplying apparatus, as described later in connection with the third embodiment.

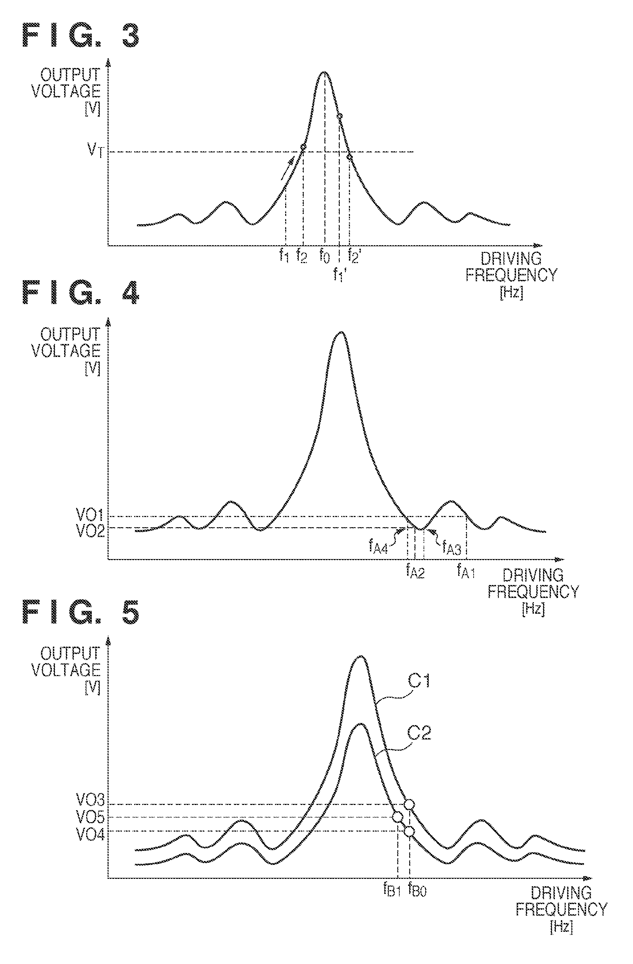

Fig. 3 shows the characteristics of the output voltage with respect to the frequency of the piezoelectric transformer 101. The output voltage reaches a maximum at a resonance frequency f0. Therefore, in a frequency region lower than f0, the output voltage rises as the frequency increases. In a frequency region higher than f0, however, the output voltage rises as the frequency decreases. That is, in the left half region, the frequency is increased from a first frequency f1 step by step, and a second frequency f2 when the output voltage crosses (exceeds) a target voltage value VT is stored in the RAM 141. On the other hand, in the right half region, the frequency is decreased from a first frequency f1' step by step, and a second frequency f2' when the output voltage crosses (falls below) the target voltage value VT is stored in the RAM 141. In practice, as can be seen from Fig. 3, one problem with this method of performing control by changing the frequency of the output voltage from the piezoelectric transformer, is that there are resonance points even at frequencies other than the resonance frequency f0. A frequency at a resonance point other than f0 is called a spurious frequency. Since spurious frequencies exist, there is a region where the basic characteristics do not apply. A method of avoiding the spurious frequencies will be described in detail in the second embodiment.

Next, a fine adjustment operation for maintaining the output voltage at or close to the target voltage based on the frequency value stored in the RAM 141 will be explained with reference to Figs. 1 and 2B. For descriptive convenience, assume that VE > VF, VF < VH, and VH > VI in Fig. 2B.

The first line of Fig. 2B shows a series of timing signals (v) generated by the timing signal generation block 133 in the fine adjustment operation. In this embodiment it is assumed that the interval between successive timing signals in the fine adjustment operation is the same as the interval t1 between timing signals in the sweep operation. The second line of Fig. 2B shows the frequency of the pulse signal (vi) generated by the frequency generation block 134. The third line in Fig. 2B shows the digital values VE, VF, VH and VI which are output from the A/D converter 135. The digital values indicate the output voltage Vout of the high voltage power supplying apparatus.

The frequency (for example, 200 KHz), reached at the end of the sweep operation and stored in the RAM 141, is set as the initial frequency for the fine adjustment operation. In this embodiment the initial value corresponds to the frequency f2 (second frequency) at which the output voltage exceeds the target voltage. In the fine adjustment operation the voltage value comparison block 136 adjusts the frequency of the pulse signal by decreasing or increasing the frequency, step by step, starting from the second frequency f2 at which, in the sweep operation, the output voltage exceeded the target voltage. In synchronism with the first timing signal (see the first line of Fig. 2B), the pulse-signal frequency is set to the initial value of 200 KHz and, after the output voltage has settled, the output voltage is converted to a corresponding digital value VE. At the second timing signal the frequency generation block 134 decreases the frequency, for example, from 200 KHz to 190 KHz, as shown in the second line of Fig. 2B. The digital value output from the A/D converter 135 at this time decreases from the value VE detected at 200 KHz to the value VF. That is, since a frequency corresponding to a voltage higher than the target voltage VT is set as the initial value, decreasing the frequency is expected to maintain the output voltage at or close to the target voltage. Thus, in the case in which the second frequency f2 is a frequency at which the output voltage exceeded the target voltage at the end of the sweep operation, the initial direction of the change in frequency is a decrease. Of course, in the alternative case in which the second frequency f2' is a frequency at which the target voltage exceeded the output voltage at the end of the sweep operation, the initial direction of the change in frequency should be an increase.

The voltage value comparison block 136 determines whether the voltage value VF is equal to the target voltage VT. In this case, assume that the output voltage becomes lower than the target voltage VT. Since the output voltage is lower than the target voltage VT, the voltage value comparison block 136 instructs the frequency generation block 134 to increase the frequency. That is, the direction of the change in frequency itself changes from a decrease to an increase. The frequency generation block 134 changes the frequency from 190 KHz to 195 KHz. Note that the change amount here is set smaller than that in the sweep operation. This is because fine adjustment is desirable to adjust the frequency for maintaining the output voltage at or close to the target voltage. In the fine adjustment operation, the frequency generation block 134 makes the stepwise change amount of the frequency smaller, when the direction of the change in frequency of the pulse signal changes from a decrease to an increase or vice versa.

As shown in the third line of Fig. 2B, the output voltage rises from the voltage value VF to the voltage value VH. The voltage value comparison block 136 determines again whether the voltage value VH is equal to the target voltage VT. Assume that the output voltage becomes larger than the target voltage VT.

In this case, the voltage value comparison block 136 instructs the frequency generation block 134 to decrease the frequency. This is done to lower the output voltage. The frequency generation block 134 changes the direction of the change in frequency from an increase to a decrease, and therefore, sets the change amount smaller again. The frequency generation block 134, for example, changes the frequency from 195 KHz to 192 KHz. The change amount is changed from 5 KHz to 3 KHz. That is, the change amount becomes smaller.

With this processing, the output voltage of the piezoelectric transformer 101 decreases from the voltage value VH to the voltage value VI, as shown in vii) of Fig. 2B. The voltage value comparison block 136 determines whether the voltage value VI, is equal to the target voltage VT. In this case, since the target voltage VT = VI (at least within some permitted margin), the two voltages are determined to be equal to each other. The voltage value comparison block 136 instructs the frequency generation block 134 to continue outputting the pulse signal at the frequency of 192 KHz.

As described above, the voltage value comparison block 136 carries out a sweep operation in which the frequency is changed step by step from a first frequency to a second frequency. The initial frequency for the fine adjustment operation is set based upon the comparison results in the sweep operation. An amount by which the frequency is changed in each step of the sweep operation is greater than an amount by which the frequency is changed in at least one step of the fine adjustment operation. Accordingly, a rate of change of the pulse-signal frequency in the sweep operation is greater than a rate of change of the pulse-signal frequency in at least part of said fine adjustment operation. This makes it possible to shorten the rising time of the output voltage of the piezoelectric transformer 101 as compared with a conventional technique.

It is also possible to achieve this effect when the interval between steps is different in the fine adjustment operation from in the sweep operation. For example, the intervals may be shorter in the sweep operation than in the fine adjustment operation.

Also, in this embodiment the initial frequency for the fine adjustment operation is stored in the storage unit. That is, the value of the frequency for obtaining an output voltage equal or close to the target voltage, which has been determined by performing the sweep operation upon power-on, is stored in the RAM 141, and the target voltage is obtained using this value.

The second embodiment of the present invention will be described next. The second embodiment can be implemented using the same circuitry as shown in Fig. 1, except as explained hereinafter.

This embodiment proposes a method of avoiding the influence of the above-described spurious frequencies. If a target voltage is a low voltage, a spurious frequency may be generated due to the structural characteristics of a piezoelectric transformer 101, as shown in Fig. 4. If, for example, a pulse signal with an initial frequency corresponding to the low voltage is input to the piezoelectric transformer 101, the piezoelectric transformer 101 may output a voltage higher than the target voltage. It is, therefore, necessary to detect generation of a spurious frequency, avoid its influence, and store a frequency for obtaining the target voltage in a RAM 141. In the second embodiment, this problem is solved specifically by detecting that an output voltage becomes lower than the target voltage, and then executing a sweep operation until the output voltage becomes higher than the target voltage.

Fig. 4 shows a voltage output from the piezoelectric transformer 101 when the frequency of a pulse signal to be sent to the piezoelectric transformer 101 is changed. Reference symbol fA1 denotes a third frequency used an initial frequency for a pre-sweep operation carried out before starting the sweep operation. In the sweep operation (as in the first embodiment) the frequency is changed step by step from a first frequency to a second frequency. The first frequency is the frequency reached at the end of the pre-sweep operation. Referring to Fig. 4, fA1 belongs to a spurious frequency region. Reference symbol VO1 denotes a voltage value output from the piezoelectric transformer 101 with respect to the initial frequency; VO2, a target voltage value; fA2, the frequency (ideal frequency) of the pulse signal to be sent to the piezoelectric transformer 101 with respect to the target voltage value; fA3, the first frequency of the sweep operation, which in this example is the frequency of the pulse signal which is sent to the piezoelectric transformer 101 when the voltage value of the output voltage of the piezoelectric transformer 101 falls below the target voltage value; and fA4, the second frequency of the sweep operation, which in this example is the frequency of the pulse signal which is sent to the piezoelectric transformer 101 when the voltage value of the output voltage of the piezoelectric transformer 101 exceeds the target voltage value VO2.

When data indicating start of the pre-sweep operation is set in the register 131 by the CPU 140, the measurement start signal generation block 132 sends a measurement start signal to the timing signal generation block 133. Upon input of the measurement start signal, the timing signal generation block 133 generates a timing signal, and sends it to a frequency generation block 134. Each time the frequency generation block 134 receives the timing signal, it changes the frequency of a pulse signal step by step. The initial frequency (third frequency) fA1 of the frequency generation block 134 is a value which has been set in the register 131 by the CPU 140. As in the first embodiment, the CPU 140 determines the initial frequency fA1 in accordance with a voltage needed by a load. The frequency generation block 134 generates and outputs a pulse signal with the set initial frequency fA1. For the initial frequency fA1, a voltage value output from the piezoelectric transformer 101 is VO1, as shown in Fig. 4. A voltage value comparison block 136 determines that the voltage value VO1 is larger than the target voltage value VO2. The voltage value comparison block 136 writes, into the register 131, data indicating that the initial voltage value VO1 is larger than the target voltage value VO2. As described above, the voltage value comparison block 136 compares the output voltage Vout detected by the voltage detection unit with the target voltage and writes the comparison result in the register 131.

The CPU 140 reads the comparison result written in the register 131. In this example, in the pre-sweep operation the CPU 140 instructs the frequency generation block 134 to decrease the frequency of the pulse signal, starting from the initial frequency (third frequency) fA1, until a voltage value larger than the target voltage value VO2 is output after an output voltage value becomes smaller than the target voltage value VO2. That is, in this example the CPU 140 functions as a unit which controls the frequency generation block 134 to decrease the frequency of the pulse signal from the initial frequency step by step until the output voltage falls below the target voltage. At this point, the pre-sweep operation ends with the frequency at the first frequency fA3 of the sweep operation. The CPU 140 then functions as a unit which controls the frequency generation block 134 to decrease the frequency of the pulse signal further, step by step, until the output voltage exceeds the target voltage. At this point, the sweep operation ends with the frequency at the second frequency fA4. Thus, the CPU causes the sweep operation to be carried out only once it confirms in the pre-sweep operation that the output voltage falls below the target voltage.

Based on the timing signal sent from the timing signal generation block 133, the frequency generation block 134 changes, step by step, the frequency of the pulse signal to be sent to the piezoelectric transformer 101 until a voltage value smaller than the target voltage value VO2 is output. In this example, the frequency decreases step by step. Consequently, when the frequency becomes fA3, the output voltage value becomes smaller than the target voltage value VO2. When the voltage value comparison block 136 detects that the output voltage value becomes smaller than the target voltage value VO2, the frequency generation block 134 keeps on decreasing the frequency. The frequency generation block 134 decreases the frequency of the pulse signal step by step until the voltage value comparison block 136 determines that the output voltage exceeds the target voltage.

When the voltage value comparison block 136 detects that that the output voltage value becomes larger than the target voltage value VO2 again, the frequency generation block 134 writes the frequency fA4 at this time into the register 131. The CPU 140 stores the value of the frequency fA4 in the RAM 141. A fine adjustment operation, for maintaining the output voltage at or close to the target voltage based on the frequency value fA4 stored in the RAM 141, and the frequency recording processing are the same as in the first embodiment, and a detailed description thereof will not be repeated. The fine adjustment operation starts when the voltage value comparison block 136 detects that the output voltage value becomes larger than the target voltage value VO2, the frequency generation block 134 changes the frequency from a decrease to an increase. The frequency generation block 134 switches the frequency of the pulse signal step by step until the voltage value comparison block 136 determines that the output voltage does not exceed the target voltage. However, as in the first embodiment, fine adjustment of the frequency may be implemented by making the change amount smaller, for example, by changing the change amount of the frequency from 10 KHz to 5 KHz, when changing the direction of change in frequency from a decrease to an increase. The final frequency ends up at fA2, intermediate between fA3 and fA4, at which V = VO2 (at least within some permitted margin).

As described above, according to the second embodiment, it is possible to output a low voltage at high accuracy while avoiding the influence of spurious frequencies. Although in the example given here the frequency decreases in the pre-sweep and sweep operations, it will be appreciated that it is also possible to start from an initial frequency (third frequency) below the frequencies (first to second frequencies) used for the sweep operation and increase the frequency over the course of the pre-sweep and sweep operations.

The third embodiment will now be explained.

In the third embodiment, a method of solving a problem that a voltage value output from a piezoelectric transformer 101 changes when a load change occurs will be described. That is, in the third embodiment, when a load change is detected, the sweep operation is re-executed, thereby solving this problem.

Fig. 5 is a view showing the relationships between the output voltage value and frequency of the piezoelectric transformer 101 before and after a load change occurs. A frequency characteristic curve C1 indicates a frequency characteristic before the load change occurs. A frequency characteristic curve C2 represents a frequency characteristic after the load change occurs. Reference symbol fB0 denotes a frequency of a pulse signal with respect to a target voltage before the load change occurs; VO3, an output voltage value with respect to the frequency fB0 before the load change occurs; VO4, an output voltage value with respect to the frequency fB0 after the load change occurs; fB1, the frequency of a pulse signal which is set as an initial value by a CPU 140 when the load change occurs; and VO5, an output voltage value corresponding to the frequency fB1.

The CPU 140 functions as a load detection unit which detects a load change with respect to a high voltage power supplying apparatus. The CPU 140 also detects a load change by direct detection from a load, or by detecting a change in the relationship between the frequency and the output voltage. Upon detection of a load change, the CPU 140 re-executes the sweep operation. To re-execute the sweep operation, the frequency fB0 stored in a RAM 141 is referred to. That is, the CPU 140 sets, in the register 131, the frequency fB0 stored in the RAM 141. A frequency generation block 134 outputs a pulse signal in accordance with the frequency fB0 set in the register 131. Based on the voltage value VO4 output from the piezoelectric transformer 101 upon sending the frequency fB0, the CPU 140 determines a frequency to be output next.

If, for example, a load change occurs, as shown in Fig. 5, the output voltage may become lower than that before the load change occurs. The CPU 140, therefore, decreases the frequency to raise the output voltage. That is, the CPU 140 sets the frequency fB1 in the register 131. The frequency generation block 134 generates a pulse signal with the frequency fB1, and outputs it to the piezoelectric transformer 101. As shown in Fig. 5, the piezoelectric transformer 101 outputs a voltage with the voltage value VO5. After that, a frequency at which the output voltage exceeds a voltage with the target voltage value VO3 or larger is stored in the RAM 141, as in the first embodiment.

According to the third embodiment, upon detecting a load change, the CPU 140 or the like controls a pulse generation unit to increase or decrease the frequency of the pulse signal step by step until the output voltage exceeds the target voltage again. With this processing, the value of a frequency at which the output voltage is equal to the target voltage is swept. As a result, even if a load change occurs, it is possible to recover the target voltage at an early stage.

The above power supplying apparatus can be adopted as a power supplying apparatus for an image forming apparatus. An electrophotographic image forming apparatus has a latent image forming unit (for example, a charging roller or exposure apparatus) which forms an electrostatic latent image on an image carrier, a developing unit (for example, a developing roller) which develops the electrostatic latent image into a toner image, a transfer unit (for example, a transfer roller) which transfers the toner image onto a transfer member, and a fixing unit (for example, a fixing roller or pressing roller) which heats and fixes the toner image on the transfer member. Particularly, the power supplying apparatus supplies at least one of a charging bias applied to the image carrier, a developing bias applied to the developing unit, and a transfer bias applied to the transfer unit. If the control speed in the power supplying apparatus improves, it is possible to shorten the time from startup of the image forming apparatus until an image is formed on a printing paper sheet and the printing paper sheet is discharged.

Note that it is also possible to configure, as an IC, the ASIC 130 described above in the first to third embodiments. Pulse signal generating circuitry embodying the first aspect of the present invention may be implemented by such an ASIC 130 by itself or in combination with the CPU 140.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. Pulse signal generating circuitry, for generating a pulse signal (iii) to be applied to high-voltage power supplying circuitry (101-113), the high-voltage power supplying circuitry having a piezoelectric transformer (101) which receives at its primary side said pulse signal or a signal derived therefrom and which outputs at its secondary side a voltage dependent upon the frequency of the pulse signal, from which secondary-side voltage an output voltage (Vout) of the high-voltage power supplying circuitry is derived, the pulse signal generating circuitry (130) comprising:
comparing means (136) for comparing said output voltage with a target voltage (VT; VO2);
control means (131-134) adapted to change the frequency of the pulse signal (iii) in dependence upon the comparison results, the control means being operable to carry out a fine adjustment operation (Fig. 2B) in which the pulse-signal frequency is adjusted, starting from an initial frequency(f2; fA4), so as to tend to maintain the output voltage at or close to the target voltage, the control means being further operable, prior to said fine adjustment operation, to carry out a sweep operation (Fig. 2A) in which the pulse-signal frequency is changed step by step from a first frequency (f1; fA3) to a second frequency (f2; fA4), the target voltage (VT; VO2) being higher than the output voltage at one (f1; fA3) of said first and second frequencies and the output voltage being higher than the target voltage at the other (f2; fA4) of said first and second frequencies, and to set said initial frequency based on the comparison results obtained from the sweep operation,
wherein a rate of change of said pulse-signal frequency in said sweep operation is greater than a rate of change of said pulse-signal frequency in at least part of said fine adjustment operation.

2. The circuitry according to claim 1, wherein the pulse-signal frequency is changed in one direction only during the sweep operation.

3. The circuitry according to claim 1 or 2, wherein the pulse-signal frequency is increasable and decreasable during the fine adjustment operation.

4. The circuitry according to claim 1, 2 or 3, wherein said rate of change is constant during the sweep operation.

5. The circuitry according to any preceding claim, wherein said rate of change is variable during the fine adjustment operation.

6. The circuitry according to any preceding claim, wherein said rate of change is decreased during the fine adjustment operation when the output voltage changes from being less than the target voltage to being higher than the target voltage, or vice versa.

7. The circuitry according to any preceding claim, wherein the pulse-signal frequency is changed step by step in the fine adjustment operation, and an amount by which the pulse-frequency is changed in at least one step of the fine adjustment operation is smaller than an amount by which the pulse-frequency is changed in each step of the sweep operation.

8. The circuitry according to claim 2 or any one of claims 3 to 7 when read as appended to claim 2, wherein the control means are operable, prior to the sweep operation, to set the pulse-signal frequency to a third frequency (fA1) such that said first frequency (fA3) is intermediate between said second and third frequencies (fA4, fA1) and said third frequency, and are further operable, in the case in which the output voltage is higher than the target voltage at said second and third frequencies (fA4, fA1), to change the pulse-signal frequency in said one direction from the third frequency until the pulse-signal frequency reaches a frequency, being said first frequency (fA3), at which the target voltage becomes higher than the output voltage, and are further operable, in the case in which the target voltage is higher than the output voltage at said second and third frequencies, to change the pulse-signal frequency in said one direction from the third frequency until the pulse-signal frequency reaches a frequency, being said first frequency, at which the output voltage becomes higher than the target voltage.

9. The circuitry according to any preceding claim, further comprising:
load detection means for detecting a load change of said high-voltage power supplying circuitry;
wherein said control means are responsive to detection of such a load change to carry out said sweep operation.

10. High-voltage power supplying apparatus comprising the pulse signal generating circuitry of any preceding claim and a piezoelectric transformer (101) connected to receive at its primary side said pulse signal or a signal derived therefrom and operable to output at its secondary side a voltage dependent upon the frequency of the pulse signal, from which secondary-side voltage an output voltage (Vout) of the high-voltage power supplying apparatus is derived.

11. Image forming apparatus comprising:
image forming means which forms an image;
the high-voltage power supplying apparatus according to claim 10 connected to said image forming means for applying said output voltage thereto.

12. The apparatus according to claim 11, wherein
said image forming means has an image carrier, a charging means which charges said image carrier, a latent image forming means which forms an electrostatic latent image on said image carrier, a developing means which develops the electrostatic latent image into a toner image, a transfer means which transfers the toner image onto a transfer member, and a fixing means which heats and fixes the toner image on a printing paper sheet, and
said high voltage power supplying apparatus applies a high voltage to one or more of said charging means, said developing means, and said transfer means.

## Patentansprüche

1. Impulssignalerzeugungsschaltung zum Erzeugen eines auf eine Hochspannungsstromversorgungsschaltung (101-113) anzuwendenden Impulssignals (iii), wobei die Hochspannungsstromversorgungsschaltung einen piezoelektrischen Wandler (101) aufweist, der an seiner Primärseite das Impulssignal oder ein davon abgeleitetes Signal empfängt und der an seiner Sekundärseite eine von der Frequenz des Impulssignals abhängige Spannung ausgibt, und von dessen sekundärseitiger Spannung eine Ausgabespannung (Vout) der Hochspannungsstromversorgungsschaltung abgeleitet wird, wobei die Impulssignalerzeugungsschaltung (130) umfasst:
eine Vergleichseinrichtung (136) zum Vergleichen der Ausgabespannung mit einer Zielspannung (VT; VO2); sowie
eine Steuereinrichtung (131-134), die ausgebildet ist, um die Frequenz des Impulssignals (iii) in Abhängigkeit von den Vergleichsergebnissen zu ändern, wobei die Steuereinrichtung betreibbar ist, um eine Feinanpassungsoperation (Fig. 2B) auszuführen, in der die Impulssignalfrequenz beginnend mit einer Anfangsfrequenz (f2; fA4) angepasst wird, um so die Ausgabespannung an oder nahe der Zielspannung zielweise beizubehalten, und die Steuereinrichtung weiterhin betreibbar ist, um vor der Feinanpassungsoperation eine Durchlaufoperation (Fig. 2A) auszuführen, in der die Impulssignalfrequenz schrittweise von einer ersten Frequenz (f1; fA3) in eine zweite Frequenz (f2; fA4) geändert wird, wobei bei einer (f 1; fA3) der ersten und zweiten Frequenz die Zielspannung (VT; VO2) höher als die Ausgabespannung ist und bei der anderen (f2; fA4) der ersten und zweiten Frequenz die Ausgabespannung höher als die Zielspannung ist, und um die Anfangsfrequenz basierend auf den aus der Durchlaufoperation erhaltenen Vergleichsergebnissen einzustellen, und
wobei eine Änderungsrate der Impulssignalfrequenz in der Durchlaufoperation größer als eine Änderungsrate der Impulssignalfrequenz in zumindest einem Teil der Feinanpassungsoperation ist.

2. Schaltung nach Anspruch 1, wobei die Impulssignalfrequenz während der Durchlaufoperation in nur eine Richtung geändert wird.

3. Schaltung nach Anspruch 1 oder 2, wobei die Impulssignalfrequenz während der Feinanpassungsoperation erhöht und verringert werden kann.

4. Schaltung nach Anspruch 1, 2 oder 3, wobei die Änderungsrate während der Durchlaufoperation konstant ist.

5. Schaltung nach einem vorhergehenden Anspruch, wobei die Änderungsrate während der Feinanpassungsoperation variabel ist.

6. Schaltung nach einem vorhergehenden Anspruch, wobei die Änderungsrate während der Feinanpassungsoperation verringert wird, wenn die Ausgabespannung sich von weniger als die Zielspannung zu höher als die Zielspannung ändert, oder umgekehrt.

7. Schaltung nach einem vorhergehenden Anspruch, wobei die Impulssignalfrequenz in der Feinanpassungsoperation schrittweise geändert wird und eine Menge, um welche die Impulssignalfrequenz in mindestens einem Schritt der Feinanpassungsoperation geändert wird, kleiner ist als eine Menge, um welche die Impulssignalfrequenz in jedem Schritt der Durchlaufoperation geändert wird.

8. Schaltung nach Anspruch 2 oder einem der Ansprüche 3 bis 7, wenn in Abhängigkeit von Anspruch 2 gelesen, wobei die Steuereinrichtung betreibbar ist, um vor der Durchlaufoperation die Impulssignalfrequenz auf eine dritte Frequenz (fA1) so einzustellen, dass die erste Frequenz (fA3) zwischen der zweiten und dritten Frequenz (fA4, fA1) liegt, und weiterhin betreibbar ist, um für den Fall, dass die Ausgabespannung höher als die Zielspannung bei der zweiten und dritten Frequenz (fA4, fA1) ist, die Impulssignalfrequenz in besagte eine Richtung von der dritten Frequenz aus zu ändern, bis die Impulssignalfrequenz eine Frequenz erreicht, welche die erste Frequenz (fA3) ist, bei der die Zielspannung höher als die Ausgabespannung wird, und weiterhin betreibbar ist, um für den Fall, dass die Zielspannung höher als die Ausgabespannung bei der zweiten und dritten Frequenz ist, die Impulssignalfrequenz in besagte eine Richtung von der dritten Frequenz aus zu ändern, bis die Impulssignalfrequenz eine Frequenz erreicht, welche die erste Frequenz ist, bei der die Ausgabespannung höher als die Zielspannung wird.

9. Schaltung nach einem vorhergehenden Anspruch, weiterhin umfassend:
eine Lastdetektionseinrichtung zum Detektieren einer Laständerung der Hochspannungsstromversorgungsschaltung;
wobei die Steuereinrichtung auf Detektion einer solchen Laständerung anspricht, um die Durchlaufoperation auszuführen.

10. Hochspannungsstromversorgungsvorrichtung, die die Impulssignalerzeugungsschaltung eines vorhergehenden Anspruchs umfasst sowie einen piezoelektrischen Wandler (101), der verbunden ist, um an seiner Primärseite das Impulssignal oder ein davon abgeleitetes Signal zu empfangen, und betreibbar ist, um an seiner Sekundärseite eine von der Frequenz des Impulssignals abhängige Spannung auszugeben, und von dessen sekundärseitiger Spannung eine Ausgabespannung (Vout) der Hochspannungsstromversorgungsvorrichtung abgeleitet wird.

11. Bilderzeugungsvorrichtung, umfassend:
eine Bilderzeugungseinrichtung, die ein Bild erzeugt; sowie
die Hochspannungsstromversorgungsvorrichtung nach Anspruch 10, die mit der Bilderzeugungseinrichtung verbunden ist, um daran die Ausgabespannung anzulegen.

12. Vorrichtung nach Anspruch 11, wobei
die Bilderzeugungseinrichtung aufweist: einen Bildträger, eine Aufladeeinrichtung, die den Bildträger auflädt, eine Erzeugungseinrichtung für latente Bilder, die ein elektrostatisches latentes Bild auf dem Bildträger erzeugt, eine Entwicklungseinrichtung, die das elektrostatische latente Bild in ein Tonerbild entwickelt, eine Transfereinrichtung, die das Tonerbild auf ein Transferelement transferiert, und eine Fixiereinrichtung, die das Tonerbild auf einem Druckpapierbogen erhitzt und fixiert, und
die Hochspannungsstromversorgungsvorrichtung eine Hochspannung an eine oder mehrere von der Aufladeeinrichtung, der Entwicklungseinrichtung und der Transfereinrichtung anlegt.

## Revendications

1. Montage générateur de signal impulsionnel, destiné à engendrer un signal impulsionnel (iii) à appliquer à un montage (101 à 113) d'alimentation à haute tension, le montage d'alimentation à haute tension comportant un transformateur piézoélectrique (101) qui reçoit à son côté primaire ledit signal impulsionnel ou un signal obtenu à partir de celui-ci et qui sort de son côté secondaire une tension fonction de la fréquence du signal impulsionnel, à partir de laquelle tension de côté secondaire on obtient une tension de sortie (Vout) du montage d'alimentation à haute tension, le montage (130) générateur de signal impulsionnel comprenant :
des moyens (136) de comparaison destinés à comparer ladite tension de sortie avec une tension cible (VT ; V02) ;
des moyens (131 à 134) de commande aptes à changer la fréquence du signal impulsionnel (iii) en fonction des résultats de comparaison, les moyens de commande étant utilisables pour effectuer une opération d'ajustement fin (figure 2B) dans laquelle on ajuste la fréquence de signal impulsionnel, en partant d'une fréquence initiale (f2 ; fA4), de façon à tendre à maintenir la tension de sortie à la tension cible ou proche de celle-ci, les moyens de commande étant en outre utilisables, avant ladite opération d'ajustement fin, pour effectuer une opération de balayage (figure 2A) dans laquelle on change pas à pas la fréquence de signal impulsionnel à partir d'une première fréquence (f1 ; fA3) jusqu'à une deuxième fréquence (f2 ; fA4), la tension cible (VT ; V02) étant plus haute que la tension de sortie à l'une (f1 ; fA3) desdites première et deuxième fréquences et la tension de sortie étant plus haute que la tension cible à l'autre (f2 ; fA4) desdites première et deuxième fréquences, et pour fixer ladite fréquence initiale en se basant sur les résultats de comparaison obtenus de l'opération de balayage,
dans lequel la cadence de changement de ladite fréquence de signal impulsionnel dans ladite opération de balayage est plus grande que la cadence de changement de ladite fréquence de signal impulsionnel dans au moins une partie de ladite opération d'ajustement fin.

2. Montage selon la revendication 1, dans lequel on change la fréquence de signal impulsionnel dans un sens seulement durant l'opération de balayage.

3. Montage selon la revendication 1 ou 2, dans lequel la fréquence de signal impulsionnel peut être augmentée et peut être diminuée durant l'opération d'ajustement fin.

4. Montage selon la revendication 1, 2 ou 3, dans lequel ladite cadence de changement est constante durant l'opération de balayage.

5. Montage selon l'une quelconque des revendications précédentes, dans lequel ladite cadence de changement est variable durant l'opération d'ajustement fin.

6. Montage selon l'une quelconque des revendications précédentes, dans lequel ladite cadence de changement diminue durant l'opération d'ajustement fin lorsque la tension de sortie passe de l'état plus petite que la tension cible à l'état plus haute que la tension cible, ou vice versa.

7. Montage selon l'une quelconque des revendications précédentes, dans lequel on change pas à pas la fréquence de signal impulsionnel dans l'opération d'ajustement fin, et dans lequel le montant dont on change la fréquence impulsionnelle dans au moins un pas de l'opération d'ajustement fin et plus petit que le montant dont on change la fréquence impulsionnelle dans chaque pas de l'opération de balayage.

8. Montage selon la revendication 2 ou l'une quelconque des revendications 3 à 7 lorsqu'elles dépendent de la revendication 2, dans lequel les moyens de commande sont utilisables, avant l'opération de balayage, pour fixer la fréquence de signal impulsionnel à une troisième fréquence (fA1) de sorte que ladite première fréquence (fA3) est intermédiaire entre lesdites deuxième et troisième fréquences (fA4, fA1) et ladite troisième fréquence, et sont en outre utilisables, dans le cas dans lequel la tension de sortie est plus haute que la tension cible auxdites deuxième et troisième fréquences (fA4, fA1), pour changer la fréquence de signal impulsionnel dans ledit sens à partir de la troisième fréquence jusqu'à ce que la fréquence de signal impulsionnel atteigne une fréquence, qui est ladite première fréquence (fA3) à laquelle la tension cible devient plus haute que la tension de sortie, et sont en outre utilisables, dans le cas dans lequel la tension cible est plus haute que la tension de sortie auxdites deuxième et troisième fréquences, pour changer la fréquence de signal impulsionnel dans ledit sens à partir de la troisième fréquence jusqu'à ce que la fréquence de signal impulsionnel atteigne une fréquence, qui est ladite première fréquence, à laquelle la tension de sortie devient plus haute que la tension cible.

9. Montage selon l'une quelconque des revendications précédentes comprenant en outre :
des moyens de détection de charge destinés à détecter un changement de charge dudit montage d'alimentation à haute tension,
dans lequel lesdits moyens de commande sont sensibles à la détection d'un tel changement de charge pour effectuer ladite opération de balayage.

10. Équipement d'alimentation à haute tension comprenant le montage générateur de signal impulsionnel selon l'une quelconque des revendications précédentes et un transformateur piézoélectrique (101) connecté pour recevoir à son côté primaire ledit signal impulsionnel ou un signal obtenu à partir de celui-ci et utilisable pour sortir de son côté secondaire une tension fonction de la fréquence du signal impulsionnel, à partir de laquelle tension de côté secondaire on obtient une tension de sortie (Vout) de l'équipement d'alimentation à haute tension.

11. Appareil de formation d'image comprenant :
un moyen de formation d'image qui forme une image ;
l'équipement d'alimentation à haute tension selon la revendication 10 connecté audit moyen de formation d'image pour lui appliquer ladite tension de sortie.

12. Appareil selon la revendication 11,
dans lequel ledit moyen de formation d'image possède un porteur d'image, un moyen de charge qui charge ledit porteur d'image, un moyen de formation d'image latente qui forme, sur ledit porteur d'image, une image latente électrostatique, un moyen de développement qui développe, en une image d'encre en poudre, l'image latente électrostatique, un moyen de transfert qui transfert, sur un organe de transfert, l'image d'encre en poudre, et un moyen de fixage qui chauffe et fixe l'image d'encre en poudre sur une feuille de papier d'impression, et
dans lequel ledit équipement d'alimentation à haute tension applique une haute tension à un ou plusieurs dudit moyen de charge, dudit moyen de développement et dudit moyen de transfert.
